(19) Europäisches Patentamt
European Patent Office
Office européen des brevets

(11) EP 3 118 893 A1

(12) EUROPEAN PATENT APPLICATION

(43) Date of publication:
18.01.2017 Bulletin 2017/03

(51) Int Cl.:
H01L 21/67 (2006.01)          H01L 21/677 (2006.01)
H01L 21/683 (2006.01)         H01L 21/762 (2006.01)

(21) Application number: 15176522.9

(22) Date of filing: 13.07.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA

(71) Applicant: Nokia Technologies Oy
02610 Espoo (FI)

(72) Inventors:
• Haque, Samiul
  Cambridge, CB4 1GN (GB)
• Bower, Chris
  Cambridge, CB6 3EN (GB)
• Cotton, Darryl
  Cambridge, PE27 5JX (GB)

(74) Representative: Anglesea, Christine Ruth et al
Swindell & Pearson Limited
48 Friar Gate
Derby DE1 1GY (GB)

(54) **AN APPARATUS AND METHOD FOR ENABLING TRANSFER OF TWO DIMENSIONAL MATERIALS**

(57)   An apparatus and method wherein the apparatus comprises: a first layer having a first coefficient of thermal expansion and configured to support a layer of two dimensional material; a second layer, coupled to the first layer, having a second coefficient of thermal expansion; wherein the first coefficient of thermal expansion is different to the second coefficient of thermal expansion such that a change in temperature causes deformation of at least part of the apparatus and the deformation enables transfer of the two dimensional material.

FIG. 1

EP 3 118 893 A1

**Description**

TECHNOLOGICAL FIELD

Examples of the disclosure relate to apparatus and methods for enabling transfer of two dimensional materials. In particular they relate to apparatus and methods for releasing two dimensional materials from a substrate.

BACKGROUND

Two dimensional materials such as graphene, hexagonal boron nitride, molybdenum disulphide or other materials can be used in microelectronic devices such as thin film transistors, transducers, sensors or other applications.
In order to fabricate such devices the two dimensional material may be grown on growth substrate and then transferred to a target substrate. An intermediate substrate may be used to transfer the two dimensional material from the growth substrate to the target substrate. As the two dimensional materials are very thin it can be very difficult to transfer the two dimensional material between different substrates without contaminating or doping or otherwise damaging the two dimensional material.
It is therefore useful to provide improved apparatus and methods for transferring two dimensional materials between different substrates.

BRIEF SUMMARY

According to various, but not necessarily all, examples of the disclosure there is provided an apparatus comprising: a first layer having a first coefficient of thermal expansion and configured to support a layer of two dimensional material; a second layer, coupled to the first layer, having a second coefficient of thermal expansion; wherein the first coefficient of thermal expansion is different to the second coefficient of thermal expansion such that a change in temperature causes deformation of at least part of the apparatus and the deformation enables transfer of the two dimensional material.
In some examples the transfer of the two dimensional material may comprise removing the first layer and the layer of two dimensional material from the second layer.
In some examples the transfer of the two dimensional material may comprise removing the layer of two dimensional material from the first layer.
In some examples the deformation may comprise a progressive bending of one or more layers of the apparatus which enables one or more layers of the apparatus to be separated from other layers. The deformation may comprise a progressive bending of the first layer. The deformation may comprise a progressive bending of the second layer.
In some examples increasing the temperature of the apparatus may cause the apparatus to bend in a first direction and decreasing the temperature causes the apparatus to bend in a second direction.
In some examples increasing the temperature of the apparatus may cause the apparatus to bend in a first direction and further increasing the temperature causes the apparatus to bend in a second direction.
In some examples the first layer and the second layer may have different glass transition temperatures.
In some examples the change in temperature may be applied locally to a portion of the apparatus.
In some examples the apparatus may comprise more than two layers.
In some examples the apparatus may be used in roll to roll manufacturing.
According to various, but not necessarily all, examples of the disclosure there is provided a method comprising: providing a layer of two dimensional material on a first layer of an apparatus, wherein the apparatus comprises a first layer having a first coefficient of thermal expansion and a second layer, coupled to the first layer, having a second coefficient of thermal expansion wherein the first coefficient of thermal expansion is different to the second coefficient of thermal expansion; and changing the temperature so that the difference in the coefficients of thermal expansion causes deformation of at least part of the apparatus and the deformation enables transfer of the two dimensional material.
In some examples the transfer of the two dimensional material may comprise removing the first layer and the layer of two dimensional material from the second layer.
In some examples the transfer of the two dimensional material may comprise removing the layer of two dimensional material from the first layer.
In some examples the deformation may comprise a progressive bending of one or more layers of the apparatus which enables one or more layers of the apparatus to be separated from other layers. The deformation may comprise a progressive bending of the first layer. The deformation may comprise a progressive bending of the second layer.
In some examples increasing the temperature of the apparatus may cause the apparatus to bend in a first direction and decreasing the temperature causes the apparatus to bend in a second direction.
In some examples increasing the temperature of the apparatus may cause the apparatus to bend in a first direction and further increasing the temperature causes the apparatus to bend in a second direction.

In some examples the first layer and the second layer may have different glass transition temperatures.

In some examples the change in temperature may be applied locally to a portion of the apparatus.

In some examples the apparatus may comprise more than two layers.

In some examples the method may be used in roll to roll manufacturing.

According to various, but not necessarily all, examples of the disclosure, there is provided examples as claimed in the appended claims.

BRIEF DESCRIPTION

For a better understanding of various examples that are useful for understanding the detailed description, reference will now be made by way of example only to the accompanying drawings in which:

Fig. 1 illustrates an apparatus;
Figs. 2A to 2F illustrate apparatus in use;
Figs. 3A to 3C illustrate apparatus in use;
Fig. 4 illustrates another apparatus;
Figs. 5A to 5D illustrate an apparatus in use;
Figs. 6A to 6E illustrate an example apparatus;
Fig. 7 illustrates an example apparatus in use; and
Fig. 8 illustrates an example method.

DETAILED DESCRIPTION

The figures illustrate an apparatus 1 comprising: a first layer 3 having a first coefficient of thermal expansion and configured to support a layer of two dimensional material 7; a second layer 5, coupled to the first layer 3, having a second coefficient of thermal expansion; wherein the first coefficient of thermal expansion is different to the second coefficient of thermal expansion such that a change in temperature causes deformation of at least part of the apparatus 1 and the deformation enables transfer of the two dimensional material 7.

The apparatus 1 may be for transferring a layer of two dimensional material from a first substrate to a second, different substrate. In some examples the apparatus 1 may be for releasing a two dimensional material from a growth substrate and/or transferring the two dimensional material to a target substrate.

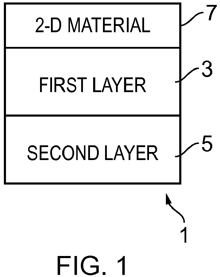

Fig. 1 schematically illustrates an apparatus 1 according to examples of the disclosure. The apparatus 1 comprises a first layer 3 and a second layer 5. The first layer 3 is configured to support a layer of two dimensional material 7.

In the example of Fig. 1 the first layer 3 is provided overlaying the second layer 5 so that the first and second layers 3, 5 form a laminar structure. It is to be appreciated that the apparatus 1 could also be provided with the second layer 5 overlaying the first layer 3.

In the example apparatus 1 of Fig. 1 the two dimensional material 7 is provided on a surface of the first layer 3. The two dimensional material 7 is provided on a first surface of the first layer 3 and the second layer 5 is coupled to the opposite surface of the first layer 3.

The layer of two dimensional material 7 may comprise a very thin layer of material. In some examples the layer of two dimensional material 7 could be an atomic monolayer. In some examples the layer of two dimensional material 7 could comprise several atomic monolayers. The layer of two dimensional material could comprise graphene, molybdenum disulphide, boron nitride or any other suitable material.

The first layer 3 and the second layer 5 are coupled together. In some examples the first and second layers 3, 5 may be bonded together. In such examples the bonds may comprise Van der Waals bonds.

In some examples the first layer 3 may be coupled to the second layer 5 so that deformation of one of the layers 3, 5 also causes deformation of the other layer 5, 3. In other examples the first layer 3 may be coupled to the second layer 5 such that deformation of one of the layers 3, 5 enables the first and second layers 3, 5 to be separated.

In the example of Fig. 1 the first layer 3 is coupled directly to the second layer 5. There are no intervening components between the first layer 3 and the second layer 5. In other examples one or more intervening components may be provided between the first layer 3 and the second layer 5. For instance, in some examples the apparatus 1 may comprise more than two layers 3, 5. In such examples one or more intervening layers could be provided between the first layer 3 and the second layer 5.

The first layer 3 has a first coefficient of thermal expansion and the second layer 5 has a second coefficient of thermal expansion. The materials that are used for the different layers 3, 5 may be selected so that the second coefficient of thermal expansion is different to the first coefficient of thermal expansion. The difference in coefficient of thermal expansions between the two layers may be arranged such that when the temperature of the apparatus 1 is changed the apparatus 1, or at least part of the apparatus, is deformed. The deformation of the apparatus 1 may enable the two dimensional material to be transferred between substrates.

Fig. 1 illustrates the apparatus 1 in an un-deformed state. In the un-deformed state each of the layers is flat or substantially flat. If the temperature of the apparatus 1, or at least part of the apparatus 1, is changed this will cause deformation of the apparatus 1. In some examples the change in temperature may cause all of the apparatus 1 to deform. In other examples the change in temperature may only cause part of the apparatus 1 to deform.

The first layer 3 and the second layer 5 may comprise any suitable materials. The materials may be chosen so that the deformation of the apparatus 1 required to transfer the two dimensional material 7 occurs at a particular temperature.

In some examples the materials used for the first layer 3 and the second layer 5 may be selected so that the two layers have a different glass transition temperature. As a material has a much smaller Young's modulus above the glass transition temperature this will cause a large reduction in the modulus for one of the layers 3, but not for the other layer. The material will also increase the coefficient of thermal expansion above the glass transition temperature. This will increase the differences in coefficient of thermal expansions at given temperatures. This property of the materials may be used to control the deformation of the apparatus 1.

The materials that are used for the respective layers 3, 5 of the apparatus 1 may be selected to have particular glass transition temperatures. The glass transition temperatures may enable the deformation of the apparatus 1 to be controlled so that the deformation occurs at specific temperatures and/or at specific locations within the apparatus 1. In some examples the materials used for the layers 3, 5 may be uniform so that the glass transition temperature is uniform throughout the material. In other examples the material may be non-uniform so that different sides of a layer 3, 5 may have different glass transition temperatures. This may enable the deformation of the apparatus 1 to be controlled by controlling the temperature.

In some examples the first and second layers 3, 5 may comprise materials such as polydimethylsiloxane (PDMS), Polyurethane, Polyethylene Naphthalate (PEN), Polyethylene terephthalate (PET), acrylic, polyimide or any other suitable materials.

In the example apparatus 1 of Fig. 1 the two dimensional material 7 is provided on a surface of the first layer 3. The two dimensional material 7 is provided on a first surface of the first layer 3 and the second layer 5 is coupled to the opposite surface of the first layer 3. In some such examples the apparatus 1 may be arranged so that both the first layer 3 and the second layer 5 provide a deformable substrate which enables the two dimensional material 7 to be transferred. In other examples the apparatus 1 may be arranged so that deformation causes the first layer 3 to separate from the second layer 5 so that only the first layer 3 supports the two dimensional material as it is being transferred.

It is to be appreciated that in some examples the two dimensional material could be provided between the first layer 3 and the second layer 5. In such examples the deformation of the apparatus 1 may enable the first layer 3 to separate from the second layer 5 which may enable the two dimensional material 7 to be transferred from the first layer 3 to the second layer 5.

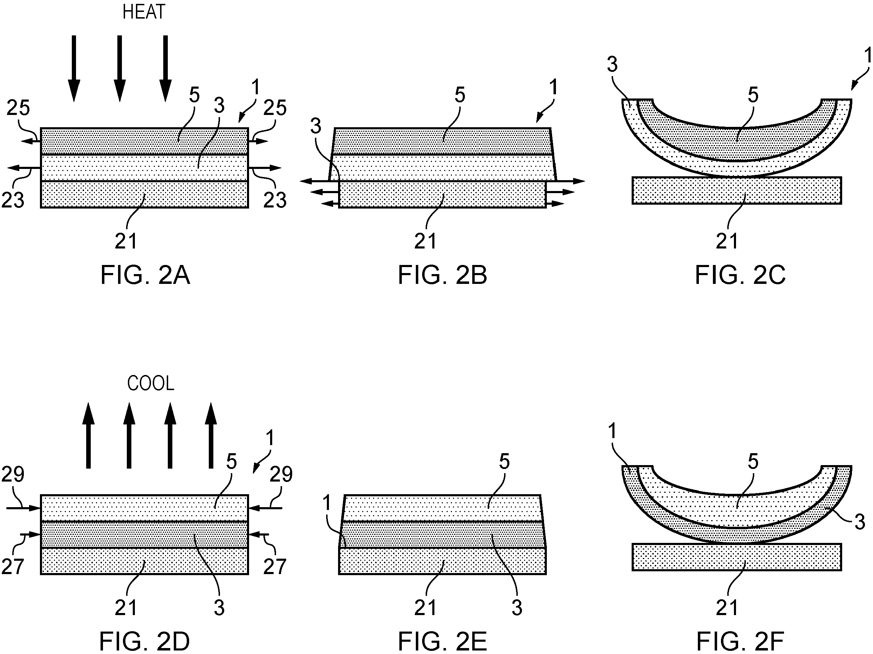

Figs. 2A to 2F illustrate two example apparatus 1 in use. Figs. 2A to 2C illustrate a first example apparatus 1 attached to a substrate 21. Figs. 2D to 2F illustrate a second example apparatus 1 attached to a substrate 21.

The substrate 21 could be a growth substrate. The growth substrate 21 may comprise any material upon which a layer of two dimensional material 7 can be fabricated. In some examples the growth substrate 21 could comprise a layer of copper. In such cases the apparatus 1 may be used to remove a layer of two dimensional material 7 from the substrate 21.

In other examples the substrate 21 could be a target substrate. The target substrate could comprise a layer which is configured to receive the two dimensional material 7. The target substrate could form part of a microelectronic device. The target substrate could comprise silicon or any other suitable material. In such examples the apparatus 1 may be used to transfer the two dimensional material 7 to the substrate 21.

In the example of Figs. 2A to 2C the apparatus 1 is arranged with the first layer 3 positioned underneath the second layer 5. The first layer 3 is provided adjacent to the substrate 21 and the second layer 5 is provided overlaying the first layer 3. In the example of Figs. 2A to 2C the second layer 5 has a smaller coefficient of thermal expansion than the first layer 3. That is, the first layer 3, which is adjacent to the substrate 21, has the higher coefficient of thermal expansion.

Fig. 2A illustrates the apparatus 1 and the substrate 21 in an un-deformed state. In the un-deformed state each of the layers 3, 5 of the apparatus 1 is flat or substantially flat.

The apparatus 1 may be deformed by changing the temperature of the apparatus 1. In the example of Fig. 2A the apparatus 1 is heated. The heating of the apparatus 1 causes an expansion of the first layer 3 and the second layer 5 as indicated by the arrows 23, 25.

Fig. 2B shows the apparatus 1 after the temperature has increased. As the first layer 3 has the higher coefficient of thermal expansion than the second layer 5 the first layer 3 expands more than the second layer 5. The substrate 21 has not expanded significantly. This generates stress at the interface between the first layer 3 and the substrate 21.

To reduce the stress in the system the apparatus 1 deforms. Fig. 2C shows the apparatus 1 in a deformed state. In the example of Figs. 2A to 2C the apparatus 1 deforms by curling. The curling comprises a progressive bending of both the first and second layers 3, 5 of the apparatus 1. In the example of Fig. 2C the apparatus 1 bends away from the substrate 21 which enables the apparatus 1 to be gradually removed from the surface of the substrate 21.

Figs. 2D to 2F show another example apparatus 1. In the examples of Figs 2D to 2F the apparatus 1 is also attached to a substrate 21 however in Figs. 2D to 2F the second layer 5 has the higher coefficient of thermal expansion. That is, the first layer 3, which is adjacent to the substrate 21 has the lower coefficient of thermal expansion.

Fig. 2D illustrates the apparatus 1 and the substrate 21 in an un-deformed state. As in the previous examples, in the un-deformed state each of the layers 3, 5 of the apparatus 1 is flat or substantially flat.

The apparatus 1 may be deformed by changing the temperature of the apparatus 1. In the example of Fig. 2D the apparatus 1 is cooled. The cooling of the apparatus1 causes contraction of the first layer 3 and the second layer 5 as indicated by the arrows 27, 29.

Fig. 2E shows the apparatus 1 after it has been cooled. As the second layer 5 has the higher coefficient of thermal expansion the second layer 5 contracts more than the first layer 3. This generates stress at the interface between the first layer 3 and the second layer 5 which causes the apparatus 1 to deform. The stress generated between the first layer 3 and the substrate 21 in the example of Fig. 2E may be lower that the stress generated between the first layer 3 and the substrate 21 in the example of Fig. 2B.

Fig. 2F shows the apparatus 1 in a deformed state. In the example of Fig. 2F the apparatus 1 also deforms by curling. The curling comprises a progressive bending of both the first and second layers 3, 5 of the apparatus 1. In the example of Fig. 2F the apparatus 1 bends away from the substrate 21 which enables the apparatus 1 to be gradually removed from the surface of the substrate 21.

In the example of Figs. 2A to 2F both the first layer 3 and the second layer 5 are deformed. In other examples only one of the layers might be deformed. Also in the examples of Figs. 2A to 2F all of the apparatus 1 is deformed. In other examples only a part of the apparatus 1 might be deformed. For instance a temperature change might be applied locally to enable part of an apparatus 1 to be deformed.

The radius of curvature of the apparatus 1 when it is deformed is determined by the difference in coefficients of the thermal expansion of the respective layers 3, 5 and the Young's modulus of the materials. When the temperature of the apparatus 1 is changed different strains are induced in the different layers 3, 5 of the apparatus 1. The differences in the strains cause the apparatus 1 to deform so that the stresses within the apparatus 1 are balanced.

The strain produced in the layers 3, 5 of the apparatus 1 is given by equation 1, where $\alpha$ is the coefficient of thermal expansion and $\Delta T$ is the change in temperature.

$$1. \qquad \varepsilon = \alpha \cdot \Delta T$$

Where the layers 3, 5 are constrained, the stress produced in the layers is given by equation 2 where E is the Young's modulus of the material.

$$2. \qquad \sigma = E \cdot \alpha \cdot \Delta T$$

The radius of curvature of a bilayer apparatus 1 is given by equation 3 where E' is the lateral Youngs modulus, w and t are the width and thickness of the two materials respectively and r is the radius of curvature.

$$3. \qquad k = \frac{1}{r} = \frac{6w_1 w_2 E_1' E_2' t_1 t_2 (t_1 + t_2) \Delta\alpha \Delta T}{\left(w_1 E_1' t_1^2\right)^2 + \left(w_2 E_2' t_2^2\right)^2 + 2w_1 w_2 E_1' E_2' t_1 t_2 \left(2t_1^2 + 3t_1 t_2 + t_2^2\right)}$$

It is to be appreciated that equation 3 covers a simple case and assumes that the Young's modulus remains constant, that the apparatus 1 is free standing and the layers of the apparatus 1 are uniformly heated. However it can be seen from this equation that the curvature of the apparatus 1 is proportional to the difference in thermal coefficients of two adjacent layers.

If the apparatus 1 is heated to or above the glass transition temperature of one of the layers 3, 5 this will greatly reduce the Young's modulus and increase the thermal coefficient of expansion of that layer 3, 5. This change in the Young's modulus and thermal coefficient of expansion can enable a greater deformation of the apparatus 1.

In examples of the disclosure the deformation of the apparatus 1 may be controlled by locally cooling or heating regions of the apparatus 1 with thin strips of jetted hot or cold air. The strips of air will cause a local change in temperature of a part of the apparatus 1. The different coefficients of thermal expansion will cause local deformation of the apparatus 1.

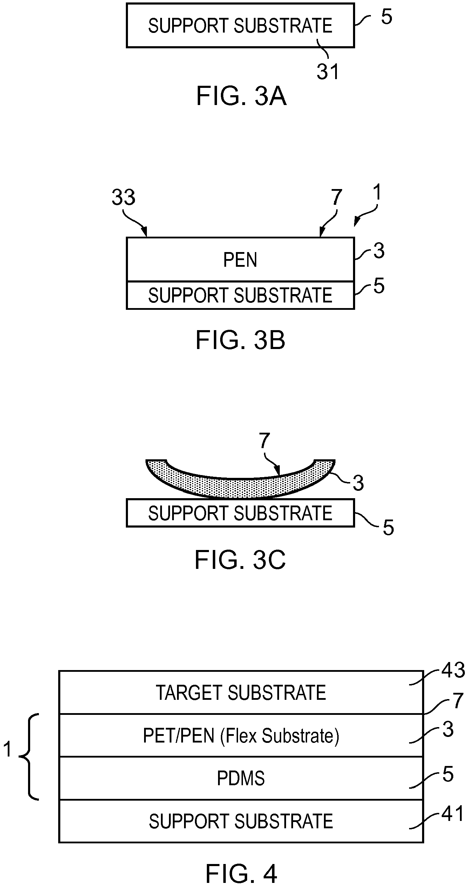

Figs. 3A to 3C illustrate another example apparatus 1 in use. The example of Figs. 3A to 3C differs from the example of Figs. 2A to 2F in that in the previous examples both layers of the apparatus 1 were deformed whereas in the example of Figs. 3A to 3C only one of the layers is deformed.

In Fig. 3A a second layer 5 of the apparatus 1 is formed. In the example of Fig. 3A the second layer 5 comprises a support substrate 31. The support substrate 31 may provide a rigid or substantially rigid substrate which may provide support while the two dimensional material 7 is being fabricated and/or patterned. The support substrate 31 may comprise a silicon wafer or any other suitable material.

The support substrate 31 may be flat or substantially flat.

In Fig. 3B the first layer 3 of the apparatus 1 is provided overlaying the second layer 5. The first layer 3 may be coupled to the second layer 5 by Van der Waals bonds or any other suitable means. In the example apparatus 1 of Fig. 3B there are no intervening layers between the first layer 3 and the second layer 5.

In this example the layer of two dimensional material 7 may be fabricated and/or patterned on the first layer 3. The two dimensional material 7 may be fabricated and/or patterned on the surface 33 of the first layer 3. The two dimensional material 7 may be formed as microelectronic devices or components of microelectronic devices. For instance the two dimensional material 7 could be formed to provide source and drain electrodes and a channel for thin film transistors (TFTs) or any other suitable components of microelectronic devices.

The two dimensional material 7 may be formed using nano-imprint or photolithography techniques or any other suitable method.

The first layer 3 may comprise a material which has a higher thermal coefficient of expansion than the second layer 5. In some examples the thermal coefficient of expansion of the first layer 3 may be much great than the thermal coefficient of expansion of the second layer 5. In the examples of Fig. 3B the first layer 3 may be formed from a polymer material such as PEN. It is to be appreciated that other materials may be used in other examples.

In Fig. 3C the apparatus 1 has been heated and is in a deformed state. The heating of the apparatus 1 causes the first layer 3 to expand more than the second layer 5. In the examples of Fig. 3C the expansion of the first layer 3 is much greater than any expansion of the second layer 5. The expansion causes stress at the interface between the first and second layers 3, 5. This stress causes the first layer 3 of the apparatus 1 to deform while the second layer 5 remains flat or substantially flat.

The deformation of the apparatus 1 comprises the progressive bending of the first layer 3. In the deformed state of Fig. 3C the first layer 3 has curled away from the support substrate 31 provided by second layer 5 while the second layer 5 has remained substantially flat. This curling may enable the first layer 3, and the layer of two dimensional material 7 which is supported by the first layer 3, to be removed from the support substrate 31 provided by the second layer 5. This may enable the two dimensional material 7 which has been fabricated on the first layer 3 to be transferred to another substrate or device. Therefore the example apparatus 1 of Figs. 3A to 3C enables the transfer of a two dimensional material 7 by removing the first layer 3 and the layer of two dimensional material 7 from the second layer 5.

The apparatus 1 may be heated to the glass transition temperature of the first layer 3. Above the glass transition temperature the Young's modulus will reduce significantly and the thermal coefficient of expansion of the first layer 3 will increase significantly. This will increase the difference in the thermal coefficient of expansion between the two layers 3, 5. Where a material such as PEN is used as the first layer 3 the glass transition temperature could be around 150°C.

In examples of the disclosure such as the examples of Figs. 3A to 3C the two dimensional material 7 can be removed from the wafer by heating the apparatus 1. There is no need for any wet processing of the apparatus 1. This may reduce the likelihood of doping and/or contamination of the two dimensional material 7.

Also the apparatus 1 does not need to be heated to a very high temperature. For examples where PEN is used as the material for the first layer 3 the apparatus could be heated to a temperature of 150°C. This may be above the glass transition temperature of a material such as PEN and so may be sufficient to cause the deformation of the first layer 3 of the apparatus 1. This temperature may still be low enough to avoid damaging the two dimensional material 7.

Fig. 4 illustrates another example apparatus 1. In this example the apparatus 1 is provided between a support substrate 41 and a target substrate 43. The example apparatus 1 of Fig. 4 may be arranged to deform in different directions so as to enable the apparatus 1 to be attached to and released from different substrates.

The example apparatus 1 of Fig. 4 comprises a first layer 3 and a second layer 5. In the example of Fig. 4 the first layer 3 may comprise a flexible polymer such as PET, PEN or any other suitable material. The second layer 5 may comprise a material such as PDMS. The first and second layers 3, 5 are coupled together. The first layer 3 may be coupled to the second layer 5 by Van der Waals interactions or any other suitable means.

The second layer 5 of the apparatus 1 is coupled to the support substrate 41. The support substrate 41 may provide a rigid support layer while the two dimensional material 7 is being formed. The two dimensional material 7 may be formed on the surface of the first layer 3. The first layer 3 may then be coupled to the target substrate 43 to enable the two dimensional material 7 to be transferred from the first layer 3 to the target substrate 43.

The temperature of the apparatus 1 may be changed in order to enable the apparatus 1 to be removed from the support substrate 41 and the target layer 43. A first change in temperature may be used to cause a deformation which enables the second layer 5 to be released from the support substrate 41 and a second change in temperature may be used to cause a deformation which enables the first layer 3 to be released from the target substrate 43.

For instance, in some examples the apparatus 1 may be deformed in a first direction by decreasing the temperature. This will cause the layer 3, 5 with the largest coefficient of thermal expansion to contract more and may cause the apparatus 1 to bend in a first direction. The apparatus 1 could then be deformed in a second direction by increasing the temperature. The heating would cause the layer with the largest coefficient of thermal expansion to expand more and may cause the apparatus 1 to bend in a second direction. The second direction could be opposite to the first direction. Therefore by following a heating pattern the apparatus 1 could be removed from both the support substrate 41 and the target substrate 43.

In the particular example of Fig. 4 the apparatus 1 could be heated to enable it to be removed from the support substrate 41. It might then be cooled to enable it to be removed from the target substrate 43. It is to be appreciated that other heating patterns could be used in other examples of the disclosure.

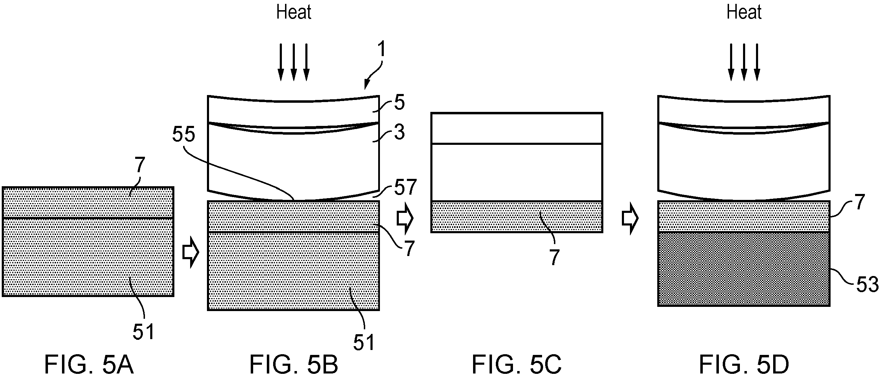

Figs. 5A to 5D illustrate another example apparatus 1 in use. In the example of Figs. 5A to 5D the apparatus 1 enables transfer of a two dimensional material 7 by enabling the layer of two dimensional material 7 to be removed from a growth substrate 51 and then removed from the first layer 3 to a target substrate 53.

In Fig. 5A a layer of two dimensional material 7 is grown on the growth substrate 51. The growth substrate 51 may comprise any material upon which a layer of two dimensional material 7 can be fabricated. In some examples the growth substrate 51 could comprise a layer of copper or any other suitable material. The layer of two dimensional material 7 could comprise graphene or any other suitable two dimensional material 7.

In Fig. 5B an apparatus 1 is provided overlaying the two dimensional material 7. The apparatus 1 comprises a first layer 3 and a second layer 5. The apparatus 1 is arranged so that the first layer 3 attaches to the two dimensional layer 7.

In the example of Fig. 5 the apparatus 1 is heated before it is positioned overlaying the two dimensional material 7. The heating of the apparatus 1 causes the apparatus 1 to curl as shown in Fig. 5B. The heated apparatus 1 may then be positioned adjacent the two dimensional material 7. When the apparatus 1 is initially positioned adjacent the two dimensional material only a first portion 55 of the first layer 3 is in contact with the two dimensional material 7. The rest of the first layer 3 is curled upwards so that a gap 57 is provided between the first layer 3 and the two dimensional material 7.

As the apparatus 1 cools it gradually uncurls so that the area 55 of the first layer 3 which is in contact with the two dimensional material 7 gradually increases. As the material uncurls any air bubbles or other pockets of gas between the apparatus 1 and the two dimensional material 7 will be pushed out. This provides for improved lamination of the apparatus 1 and the two dimensional material 7. In some examples this may allow for the apparatus 1 to self laminate with the two dimensional material 7 and the growth substrate 51.

In order to ensure good adhesion to the two dimensional material 7 the apparatus 1 may be heated above the glass transition temperature of the first layer 3. This may also allow for uniform contact across the surface of the two dimensional material 7.

Once the apparatus 1 has been attached to the two dimensional material 7 the growth substrate 51 may be removed. Fig. 5C illustrates the apparatus 1 after the growth substrate 51 has been removed. The growth substrate 51 may be removed using any suitable method. For instance where the growth substrate 51 comprises copper the growth substrate may be removed by wet etching, electrochemical oxidation or other suitable techniques.

In the example of Fig. 5C the apparatus 1 is flat or substantially flat. The apparatus 1 may be arranged in the flat configuration before the growth substrate 51 is removed.

Once the growth substrate 51 has been removed the two dimensional material 7 is left attached to the first layer 3 of the apparatus 1. The two dimensional material 7 can then be attached to a target substrate 53.

Fig. 5D illustrates the apparatus 1 being removed from the target substrate 53. The apparatus 1 is heated to cause the first layer 3 to bend away from the two dimensional material 7. The enables the controlled release of the first layer 3 from the two dimensional material 7 so that the apparatus 1 may be removed from the layer of two dimensional material 7 leaving the two dimensional material 7 on the target substrate 53.

In this example the apparatus 1 acts as a transfer substrate and enables a layer of two dimensional material 7 to be removed from a first substrate 51 and attached to another substrate 53.

In the example of Figs. 5A to 5B the first layer 3 of the apparatus 1 may have the higher coefficient of thermal expansion so that the first layer 3 of the apparatus 1 curls away from the two dimensional material 7 when it is heated but curls towards the two dimensional material 7 when it is cooled.

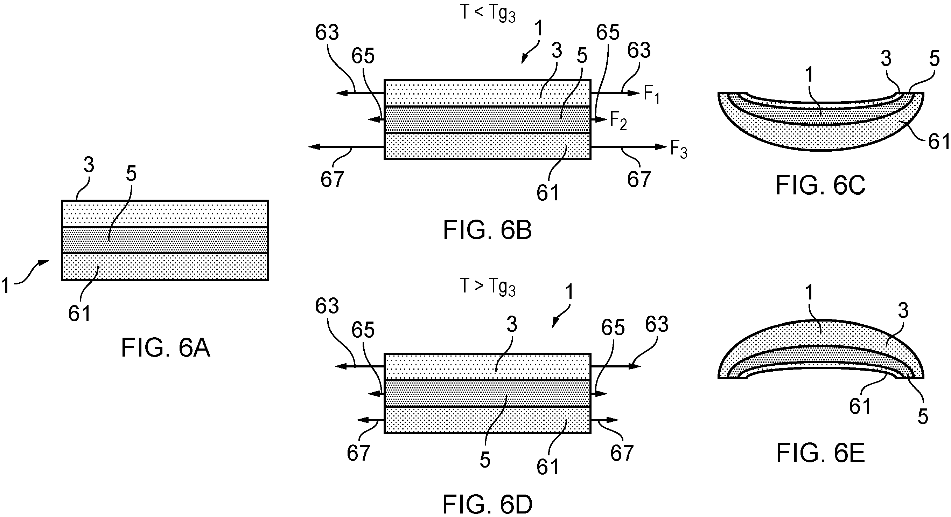

Figs. 6A to 6E illustrate an example apparatus 1 in which the apparatus 1 comprises more than two layers. In the example of Figs. 6A to 6E the apparatus 1 comprises three layers. It is to be appreciated that any other number of layers could be used in other examples of the disclosure.

In this example the apparatus 1 comprises a first layer 3, a second layer 5, and a third layer 61. The first layer 3 may be arranged to support a layer of two dimensional material 7. The layer of two dimensional material 7 is not shown in Figs. 6A to 6E. Fig. 6A illustrates the apparatus 1 in an un-deformed state. In the un-deformed state each of the layers 3, 5, 61 of the apparatus 1 is flat or substantially flat.

The first layer 3 is provided over laying the second layer 5 and the second layer 5 is provided overlaying the third layer 61 so that the three layers 3, 5, 61 form a laminar structure. It is to be appreciated that the respective layers of the apparatus 1 could be provided in a different order.

In the example apparatus 1 of Fig. 6 the two dimensional material 7 is provided on a surface of the first layer 3. The two dimensional material 7 is provided on a first surface of the first layer 3 and the second layer 5 is coupled to the opposite surface of the first layer 3. The first layer 3 is coupled to a first surface of the second layer 5 and the third layer 61 is coupled to the opposite surface of the second layer 5.

The layers 3, 5, 61 of the apparatus 1 are coupled together. The layers 3, 5, 61 may be bonded together. In such examples the bonds may comprise Van der Waals interactions.

In some examples the layers 3, 5, 61 may be bonded together so that deformation of one of the layers 3, 5, 61 also causes deformation of the other layers 3, 5, 61.

The layers 3, 5, 61 may have different coefficients of thermal expansion. In some examples each of the layers 3, 5, 61 may have different coefficients of thermal expansion. In the example of Figs. 6A to 6E the third layer 61 has the largest coefficient of thermal expansion. The third layer 61 may have a much larger coefficient of thermal expansion than the first and second layers 3, 5.

In some examples the layers 3, 5, 61 may also have different glass transition temperatures. The first layer 3 has glass transition temperature $T_{g1}$, the second layer 5 has glass transition temperature $T_{g2}$ and the third layer 61 has glass transition temperature $T_{g3}$.

In the particular example of Figs. 6A to 6E the third layer 61 has the lowest glass transition temperature such that:

$$T_{g_3} \ll T_{g_1} {\sim} T_{g_2}$$

The third layer 61 may undergo a large reduction in Young's modulus when the apparatus 1 is heated above $T_{g3}$ compared to the first and second layers 3, 5.

Fig. 6B illustrates the apparatus 1 being heated below $T_{g3}$.

The force F in each layer is given by equation 4. Where A is the cross sectional area of the apparatus 1

$$4. \qquad\qquad F = E \cdot \alpha \cdot \Delta T \cdot A$$

In Fig. 6B the force $F_1$ in the first layer 3 is indicated by the arrows 63, the force $F_2$ in the second layer 5 is indicated by the arrows 65 and the force $F_3$ in the third layer 61 is indicated by the arrows 67.

In the example of Figs. 6A to 6E the materials of the layers are chosen to have thermal coefficients of expansion, Young's modulus and glass transition temperatures such that below $T_{g3}$ the force $F_3$ in the third layer 61 is much greater than the force $F_1$ in the first layer 3 and the force $F_1$ in the first layer 3 is greater than the force $F_2$ in the second layer 5.

$$F_3 \gg F_1 > F_2$$

These forces cause the apparatus 1 to bend by curling upwards as illustrated in Fig. 6C.

Fig. 6D illustrates the apparatus 1 being heated above $T_{g3}$. Once the temperature rises above $T_{g3}$ then the Young's modulus of the third layer 61 is greatly reduced. At temperatures above $T_{g3}$ the third layer 61 becomes soft and viscoelastic so will begin to flow. This also greatly reduces the thermal expansion force $F_3$, for a given time period, in the third layer.

At temperatures above $T_{g3}$ the force $F_1$ in the first layer 3 is much greater than the force $F_3$ in the third layer 61 and the force $F_3$ in the third layer 61 is greater than the force $F_2$ in the second layer 5.

$$F_1 \gg F_3 > F_2$$

These forces cause the apparatus 1 to bend by curling downwards as illustrated in Fig. 6E.

Therefore the example apparatus 1 of Figs. 6A to 6E can be deformed in different directions by heating the apparatus 1 above the glass transition temperatures of one or more of the respective layers 3, 5, 61.

Examples of materials which could be used to form the layers 3, 5, 61 of the apparatus 1 are given in the following table

| Layer | Material | $T_g$(°C) | CTE (ppm/°C) | Modulus T < 62 (E, Pa) | Modulus T>62 (E, GPa) | Change in force per unit area ~E*CTE |
|---|---|---|---|---|---|---|
| First layer | PI- 2525 | 325 | 50 | 2.5 | 2.5 | 125 |
| Second layer | PI - 2610 | 360 | 3 | 8.5 | 8.5 | 25.5 |
| Third layer | PA | 62 | 205 | 0.73 | 0.2 | 150,41 |

In these examples the first and second layers 3, 5 may comprise polyimide (PI) and the third layer 61 may comprise polyamide (PA). The polyamide has a lower modulus than the polyimide. In other examples materials with a lower modulus such as polyacrylamide or polycarbonate could be used for the third layer 61.

The table shows the Young's modulus of the example materials at temperatures above and below the glass transition temperature of the third layer 61. The reduction in the Young's modulus of the third layer reduces the change in force per unit area from 150 to 41.

In other examples the same effect can be achieved using only two layers 3, 5. In such examples the second layer 5 could have a large coefficient of thermal expansion and a low glass transition temperature. In such examples the second layer 5 would undergo a large reduction in Young's modulus once the temperature is raised above the glass transition temperature. The first layer 3 would have a lower coefficient of thermal expansion but a higher glass transition temperature.

Examples of materials which could be used to form the layers 3, 5, of a bilayer apparatus 1 are given in the following table

| Layer | Material | $T_g$(°C) | CTE (ppm/°C.) | Modulus T < 150 (E, Pa) | Modulus T>150 (E, GPa) | Change in force per unit area ~E*CTE |
|---|---|---|---|---|---|---|
| First layer | Ph1 (50% X-linked) | 150 | 200 | 2 | 1.2 | 400,240 |
| Second layer | Ph2 (90% X-linked) | 175 | 100 | 3.4 | 3.2 | 340,320 |

In this bilayer example the reduction in forces is achieved by controlling the amount of cross-linking in a polymer layer to control the glass transition temperature. In this example the first layer 3 is a phenolic resin (Ph1) with 50% cross linking and the second layer 5 is a phenolic resin (Ph2) with 90% cross linking. Other materials and other amounts of cross linking may be used in other examples of the disclosure.

Increasing the amounts of cross-linking within the polymer results in a higher glass transition temperature and a reduced coefficient of thermal expansion. The Young's modulus also tends to increase with the amount of cross-linking within the polymer. The Young's' modulus will also have a smaller reduction at temperatures above the glass transition temperature due to increased crystallinity within the polymer.

It is to be appreciated that other materials and numbers of layers may be used in other examples of the disclosure.

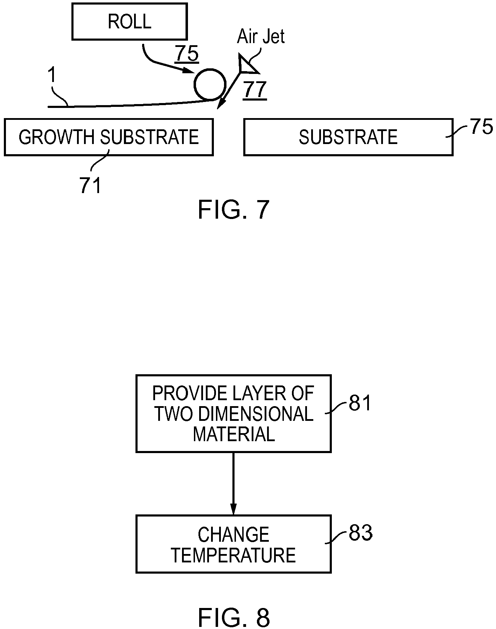

Fig. 7 illustrates an example apparatus 1 in use in a roll to roll environment.

In the example of Fig. 7 a layer of two dimensional material 7 is formed on a growth substrate 71. For instance the growth substrate 71 could comprise a copper substrate which has been used to grow graphene or any other suitable two dimensional material 7.

The roll to roll process may be used to remove the two dimensional material from the growth substrate 71 and attach it to another substrate 75. The another substrate 75 could be a post processing substrate, a target substrate, a transfer substrate or any other suitable substrate.

In the examples of Fig. 7 an apparatus 1, which may be as described above, is used to remove the two dimensional material 7 from the growth substrate 71 and attach it to the another substrate 75.

In this example deformation of the apparatus 1 may be controlled by locally cooling or heating regions of the apparatus 1 with air jets 77. The air jets 77 may comprise hot or cold air depending on the materials that are used in the apparatus 1 and the current temperatures of the apparatus 1.

The air jets 77 will cause a local change in temperature of a part of the apparatus 1. The different coefficients of thermal expansion will cause local deformation of the apparatus 1.

In the example of Fig. 7 the air jet 77 is directed towards an edge portion of the apparatus 1. This may provide the advantage that only the edge portion of the apparatus 1 is curled. This may create a higher and more focused peeling force between the apparatus 1 and the growth substrate 71. This may make the two dimensional material 7 easier to remove from the growth substrate 71.

In some examples the apparatus 1 may comprise a polyimide film. The polyimide film could be placed on top of the growth substrate 71. The growth substrate 71 and the polyimide film may then be heated to cure the polyimide. The air jet 77 may then be used to cool the top edge of the apparatus 1 which may then cause the apparatus 1 to deform and enable the two dimensional material 7 to be removed from the growth substrate 71. Once the two dimensional material 7 has been removed from the growth substrate 71 it can then be transferred to the other substrate 75.

Fig. 8 illustrates a method. The method may be implemented using example apparatus 1 as described above. The method comprises, at block 81, providing a layer of two dimensional material 7 on a first layer 3 of an apparatus 1. The apparatus 1 comprises a first layer 3 having a first coefficient of thermal expansion and a second layer 5, coupled to the first layer 3, having a second coefficient of thermal expansion. The first coefficient of thermal expansion is different to the second coefficient of thermal expansion. The method may also comprise, at block 83, changing the temperature so that the difference in the coefficients of thermal expansion causes deformation of at least part of the apparatus 1 and the deformation enables transfer of the two dimensional material 7.

Examples of the disclosure provide an improved apparatus for transferring two dimensional substrates. The apparatus 1 may enable the transfer to be carried out at low temperatures and without any wet processing which reduces the risk of damaging or contaminating the two dimensional material.

The apparatus 1 may be designed to have particular temperatures at which they deform to enable transfer of the two dimensional material 7. For instance the polymers that are used or the cross linking of the polymers may be selected so that the material deforms at a particular temperature. This may enable devices to be designed to operate at particular temperatures.

The apparatus 1 may also be designed to deform in certain ways. In some examples the apparatus 1 can curl one way at a first temperature and another way at a second temperature. These different deformations may enable the apparatus 1 to be attached to and released from different substrates.

The term "comprise" is used in this document with an inclusive not an exclusive meaning. That is any reference to X comprising Y indicates that X may comprise only one Y or may comprise more than one Y. If it is intended to use "comprise" with an exclusive meaning then it will be made clear in the context by referring to "comprising only one..." or by using "consisting".

In this detailed description, reference has been made to various examples. The description of features or functions in relation to an example indicates that those features or functions are present in that example. The use of the term "example" or "for example" or "may" in the text denotes, whether explicitly stated or not, that such features or functions are present in at least the described example, whether described as an example or not, and that they can be, but are not necessarily, present in some of or all other examples. Thus "example", "for example" or "may" refers to a particular instance in a class of examples. A property of the instance can be a property of only that instance or a property of the class or a property of a subclass of the class that includes some but not all of the instances in the class. It is therefore implicitly disclosed that a features described with reference to one example but not with reference to another example, can where possible be used in that other example but does not necessarily have to be used in that other example.

Although embodiments of the present invention have been described in the preceding paragraphs with reference to various examples, it should be appreciated that modifications to the examples given can be made without departing from the scope of the invention as claimed.

Features described in the preceding description may be used in combinations other than the combinations explicitly described.

Although functions have been described with reference to certain features, those functions may be performable by other features whether described or not.

Although features have been described with reference to certain embodiments, those features may also be present in other embodiments whether described or not.

Whilst endeavoring in the foregoing specification to draw attention to those features of the invention believed to be of particular importance it should be understood that the Applicant claims protection in respect of any patentable feature or combination of features hereinbefore referred to and/or shown in the drawings whether or not particular emphasis has been placed thereon.

**Claims**

1. An apparatus comprising:

   a first layer having a first coefficient of thermal expansion and configured to support a layer of two dimensional material;
a second layer, coupled to the first layer, having a second coefficient of thermal expansion;
wherein the first coefficient of thermal expansion is different to the second coefficient of thermal expansion such that a change in temperature causes deformation of at least part of the apparatus and the deformation enables transfer of the two dimensional material.

2. An apparatus as claimed in any preceding claim wherein the transfer of the two dimensional material comprises removing the first layer and the layer of two dimensional material from the second layer.

3. An apparatus as claimed in claim 1 wherein the transfer of the two dimensional material comprises removing the layer of two dimensional material from the first layer.

4. An apparatus as claimed in any preceding claim wherein the deformation comprises a progressive bending of one or more layers of the apparatus which enables one or more layers of the apparatus to be separated from other layers.

5. An apparatus as claimed in claim 4 wherein the deformation comprises a progressive bending of the first layer.

6. An apparatus as claimed in any of claims 4 to 5 wherein the deformation comprises a progressive bending of the second layer.

7. An apparatus as claimed in any preceding claim wherein increasing the temperature of the apparatus causes the apparatus to bend in a first direction and decreasing the temperature causes the apparatus to bend in a second direction.

8. An apparatus as claimed in any preceding claim wherein increasing the temperature of the apparatus causes the apparatus to bend in a first direction and further increasing the temperature causes the apparatus to bend in a second direction.

9. An apparatus as claimed in any preceding claim wherein the first layer and the second layer have different glass transition temperatures.

10. An apparatus as claimed in any preceding claim wherein the change in temperature is applied locally to a portion of the apparatus.

11. An apparatus as claimed in any preceding claim wherein the apparatus comprises more than two layers.

12. An apparatus as claimed in any preceding claim wherein the apparatus is used in roll to roll manufacturing.

13. A method comprising:

providing a layer of two dimensional material on a first layer of an apparatus, wherein the apparatus comprises a first layer having a first coefficient of thermal expansion and a second layer, coupled to the first layer, having a second coefficient of thermal expansion wherein the first coefficient of thermal expansion is different to the second coefficient of thermal expansion; and
changing the temperature so that the difference in the coefficients of thermal expansion causes deformation of at least part of the apparatus and the deformation enables transfer of the two dimensional material.

14. A method as claimed in claim 13 wherein the transfer of the two dimensional material comprises removing the first layer and the layer of two dimensional material from the second layer.

15. A method as claimed in claim 13 wherein the transfer of the two dimensional material comprises removing the layer of two dimensional material from the first layer.

| | |
|---|---|
| 2-D MATERIAL | 7 |
| FIRST LAYER | 3 |
| SECOND LAYER | 5 |

1

FIG. 1

FIG. 2A

FIG. 2B

FIG. 2C

FIG. 2D

FIG. 2E

FIG. 2F

SUPPORT SUBSTRATE ⌐ 5

31

FIG. 3A

33      7   1

PEN ⌐ 3

SUPPORT SUBSTRATE ⌐ 5

FIG. 3B

7

3

SUPPORT SUBSTRATE

5

FIG. 3C

| | TARGET SUBSTRATE | 43 |
| | | 7 |
| 1 { | PET/PEN (Flex Substrate) | 3 |
| | PDMS | 5 |
| | SUPPORT SUBSTRATE | 41 |

FIG. 4

Heat

55

7

1

5

3

57

7

51

51

FIG. 5A          FIG. 5B          FIG. 5C

Heat

7

53

7

FIG. 5D

EP 3 118 893 A1

FIG. 6A

FIG. 6B

FIG. 6C

FIG. 6D

FIG. 6E

ROLL

75

Air Jet

1

77

GROWTH SUBSTRATE

71

SUBSTRATE

75

FIG. 7

PROVIDE LAYER OF
TWO DIMENSIONAL
MATERIAL

81

CHANGE
TEMPERATURE

83

FIG. 8

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 682 990 B1 (IWANE MASAAKI [JP] ET AL) 27 January 2004 (2004-01-27) | 1-3,9-15 | INV.<br>H01L21/67 |
| A | * abstract *<br>* claim 1 *<br>* column 2, lines 55-63 *<br>* column 3, lines 16-25 *<br>* column 5, lines 25-28 *<br>* column 8, lines 51-65 *<br>* figures 1A-1C * | 4-8 | H01L21/677<br>H01L21/683<br>H01L21/762 |
| A | WO 2014/181855 A1 (NIPPON ELECTRIC GLASS CO [JP]) 13 November 2014 (2014-11-13)<br>* abstract *<br>* figure 1 * | 1-15 | |
| A | US 2003/224621 A1 (OSTERGARD TONI [FI] ET AL) 4 December 2003 (2003-12-04)<br>* abstract *<br>* claim 1 *<br>* figures 5-8 * | 1-15 | |

----- 

TECHNICAL FIELDS
SEARCHED (IPC)

H01L

The present search report has been drawn up for all claims

| Place of search | Date of completion of the search | Examiner |
|---|---|---|
| The Hague | 28 October 2015 | Lachaud, Stéphane |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 15 17 6522

This annex lists the patent family members relating to the patent documents cited in the above-mentioned European search report.
The members are as contained in the European Patent Office EDP file on
The European Patent Office is in no way liable for these particulars which are merely given for the purpose of information.

28-10-2015

| Patent document cited in search report | | Publication date | Patent family member(s) | | Publication date |
|---|---|---|---|---|---|
| US 6682990 | B1 | 27-01-2004 | JP<br>US | 2001085715 A<br>6682990 B1 | 30-03-2001<br>27-01-2004 |
| WO 2014181855 | A1 | 13-11-2014 | TW<br>WO | 201442875 A<br>2014181855 A1 | 16-11-2014<br>13-11-2014 |
| US 2003224621 | A1 | 04-12-2003 | NONE | | |

EPO FORM P0459

For more details about this annex : see Official Journal of the European Patent Office, No. 12/82